# EUROPEAN PATENT APPLICATION

(11) **EP 4 475 604 A1**
(43) Date of publication of application: **11.12.2024**
(21) Application number: 23762944.9
(22) Date of filing: 02.03.2023
(51) Int. Cl.: H04W 52/02

(54) **CONTROL METHOD AND APPARATUS, DEVICE AND STORAGE MEDIUM**

(30) Priority: 02.03.2022 CN 202210200238
(71) Applicant: CHINA MOBILE COMMUNICATION CO., LTD. RESEARCH INSTITUTE, Beijing 100053 (CN); CHINA MOBILE COMMUNICATIONS GROUP CO., LTD., Beijing 100032 (CN)
(72) Inventor: SONG, Dan, Beijing 100032 (CN); SONG, Xiaoxiong, Beijing 100032 (CN); LI, Nan, Beijing 100032 (CN); DENG, Wei, Beijing 100032 (CN); DING, Haiyu, Beijing 100032 (CN); LU, Songhe, Beijing 100032 (CN); LI, Binjie, Beijing 100032 (CN)
(74) Representative: Hertin und Partner Rechts- und Patentanwälte PartG mbB
(86) International application number: PCT/CN2023/079186
(87) International publication number: WO 2023/165546

(57) **Abstract**

The present disclosure provides a control method and device, apparatus and a storage medium. The method includes: determining a first parameter corresponding to an output power with a highest occurrence probability in a target output power range of a power amplifier in a terminal, where the first parameter is used to optimize and control a power added efficiency of the power amplifier; and optimizing the power added efficiency of the power amplifier by using the first parameter.

## Description

### CROSS-REFERENCE TO RELATED APPLICATION

The present disclosure claims the priority of Chinese Application No. 202210200238.3, filed on March 2, 2022, the disclosure of which is incorporated in its entirety by reference herein.

### TECHNICAL FIELD

The present disclosure relates to the field of wireless communication technologies, and in particular to a control method, apparatus, device and storage medium.

### BACKGROUND

At present, terminals have been plagued by power consumption, and how to optimize terminal power consumption has been an issue actively discussed in the industry. As a power amplifier is the "big power consumer" of terminal power consumption, terminal and power amplifier manufacturers have been actively working on optimizing power added efficiency of the power amplifier. However, the effect of optimizing the power added efficiency of the power amplifier is relatively poor, resulting in a poor effect on improving the terminal power consumption performance.

Therefore, there is an urgent need to provide a new technical solution for optimizing the power added efficiency of the power amplifier.

### SUMMARY

In view of this, embodiments of the present disclosure are intended to provide a control method, device, apparatus and storage medium.

The technical solution of the embodiments of the present disclosure is implemented as follows.

At least one embodiment of the present disclosure provides a control method, which is applied to a terminal, and the method includes:
determining a first parameter corresponding to an output power with a highest occurrence probability in a target output power range of a power amplifier in a terminal, wherein the first parameter is used to optimize and control a power added efficiency of the power amplifier;
optimizing the power added efficiency of the power amplifier by using the first parameter.

Further, the determining a first parameter corresponding to an output power with a highest occurrence probability in a target output power range of a power amplifier in a terminal, includes:
determining a second parameter; wherein the second parameter represents at least one of a current location of the terminal, a current ambient temperature of the terminal, a preset time range, and a future moment;
using the second parameter to determine the first parameter corresponding to the output power with the highest occurrence probability in the target output power range of the power amplifier in the terminal.

Further, the second parameter represents the current location of the terminal; the using the second parameter to determine the first parameter corresponding to the output power with the highest occurrence probability in the target output power range of the power amplifier in the terminal, includes:
determining the output power with the highest occurrence probability in the target output power range of the power amplifier in the terminal by using the current location of the terminal represented by the second parameter;
determining the first parameter according to the determined output power.

Further, the second parameter represents the current location of the terminal; the using the second parameter to determine the first parameter corresponding to the output power with the highest occurrence probability in the target output power range of the power amplifier in the terminal, includes:
transmitting the current location of the terminal represented by the second parameter to a first server, wherein the current location of the terminal is used for the first server to determine the first parameter corresponding to the output power with the highest occurrence probability in the target output power range of the power amplifier in the terminal;
receiving the first parameter transmitted by the first server.

Further, the second parameter represents the current location of the terminal; the using the second parameter to determine the first parameter corresponding to the output power with the highest occurrence probability in the target output power range of the power amplifier in the terminal, includes:
transmitting the current location of the terminal represented by the second parameter to a second server, wherein the current location of the terminal is used for the second server to determine the first parameter corresponding to the output power with the highest occurrence probability in the target output power range of the power amplifier in the terminal;
receiving indication information transmitted by the second server; wherein the indication information is used to indicate the first parameter;
determining the first parameter according to the indication information.

Further, the determining a first parameter corresponding to an output power with a highest occurrence probability in a target output power range of a power amplifier in a terminal, includes:
determining a power headroom report; wherein the power headroom report carries first information and second information, the first information represents a difference between a terminal's maximum allowable transmission power and a currently evaluated transmission power of a physical uplink shared channel, and the second information represents a terminal's maximum allowable transmission power on a current carrier at a current serving cell;
transmitting the power headroom report to a first network equipment; wherein the power headroom report is used for the first network equipment to parse to obtain the first information and the second information and send the first information and the second information to a first electronic device; the first information and the second information are used for the first electronic device to determine the output power with the highest occurrence probability in the target output power range of the power amplifier in the terminal in at least one of the following situations: at a location of the first network equipment, at an ambient temperature of the first network equipment, in a preset time range, and in future moment;
receiving the output power with the highest occurrence probability sent by the first electronic device;
determining the first parameter based on the output power.

Further, the determining a first parameter corresponding to an output power with a highest occurrence probability in a target output power range of a power amplifier in a terminal, includes:
receiving a first parameter transmitted by a second electronic device; wherein the first parameter is an operation parameter corresponding to an output power with the highest occurrence probability in the target output power range of the power amplifier in the terminal, and the output power with the highest occurrence probability in the target output power range of the power amplifier in the terminal is determined by the second electronic device according to an output power probability distribution diagram of the power amplifier in the terminal obtained in at least one of the following situations:
at a location of the first network equipment;
at an ambient temperature of the first network equipment;
in a preset time range;
in future moments.

Further, the determining a first parameter corresponding to an output power with a highest occurrence probability in a target output power range of a power amplifier in a terminal, includes:
obtaining the first parameter from the terminal locally; wherein the first parameter is pre-written into the terminal by a third electronic device; the first parameter is an operation parameter corresponding to an output power with the highest occurrence probability in the target output power range of the power amplifier in the terminal, and the output power with the highest occurrence probability in the target output power range of the power amplifier in the terminal is determined by the third electronic device according to an output power probability distribution diagram of the power amplifier in the terminal obtained in at least one of the following situations:
at a location of the first network equipment;
at an ambient temperature of the first network equipment;
in a preset time range;
in future moments;
   or,
obtaining the first parameter from the terminal locally; wherein the first parameter is pre-written into the terminal by a fourth electronic device; the first parameter is an operation parameter, which is determined by the fourth electronic device and is corresponding to an output power with the highest occurrence probability in the target output power range of the power amplifier in the terminal; and the output power with the highest occurrence probability in the target output power range of the power amplifier in the terminal is transmitted from the third electronic device to the fourth electronic device; and the output power with the highest occurrence probability in the target output power range of the power amplifier in the terminal is determined by the third electronic device according to an output power probability distribution diagram of the power amplifier in the terminal obtained in at least one of the following situations:
   at a location of the first network equipment;
   at an ambient temperature of the first network equipment;
   in a preset time range;
   in future moments;
      or,
   obtaining the first parameter from the terminal locally; wherein the first parameter is pre-written into the terminal by a fifth electronic device; the first parameter is an operation parameter, which is determined by the fourth electronic device and is corresponding to an output power with the highest occurrence probability in the target output power range of the power amplifier in the terminal; the first parameter is transmitted from the fourth electronic device to the fifth electronic device; and the output power with the highest occurrence probability in the target output power range of the power amplifier in the terminal is transmitted from the third electronic device to the fourth electronic device; and the output power with the highest occurrence probability in the target output power range of the power amplifier in the terminal is determined by the third electronic device according to an output power probability distribution diagram of the power amplifier in the terminal obtained in at least one of the following situations:
      at a location of the first network equipment;
      at an ambient temperature of the first network equipment;
      in a preset time range;
      in future moments.

Further, output powers with the highest occurrence probability in the target output power range of the power amplifier form N first-output power ranges, and each of the first-output power range includes M output powers; N, M are positive integers;
wherein each of the first-output power range includes the same or different amounts of output powers.

One embodiment of the present disclosure provides a control device, including:
a first processing unit configured to determine a first parameter corresponding to an output power with a highest occurrence probability in a target output power range of a power amplifier in a terminal, wherein the first parameter is used to optimize and control a power added efficiency of the power amplifier;
a second processing unit configured to optimize the power added efficiency of the power amplifier by using the first parameter.

One embodiment of the present disclosure provides a terminal, including:
a communication interface;
a processor configured to determine a first parameter corresponding to an output power with a highest occurrence probability in a target output power range of a power amplifier in a terminal, wherein the first parameter is used to optimize and control a power added efficiency of the power amplifier; and optimize the power added efficiency of the power amplifier by using the first parameter.

At least one embodiment of the present disclosure provides a terminal, including: a processor and a memory for storing a computer program capable of executed by the processor;
wherein the processor is configured to, when executing the computer program, performs steps of any of the above methods.

At least one embodiment of the present disclosure provides a computer-readable storage medium, including a computer program stored thereon; wherein the computer program, when executed by a processor, performs steps of any of the above methods.

The control method, device, apparatus and storage medium provided by the embodiments of the present disclosure determine a first parameter corresponding to an output power with a highest occurrence probability in a target output power range of a power amplifier in a terminal, wherein the first parameter is used to optimize and control a power added efficiency of the power amplifier; optimizing the power added efficiency of the power amplifier by using the first parameter. According to the technical solution provided by the embodiments of the present disclosure, PAE optimization is performed for the output power with the highest probability of the power amplifier in the terminal in the existing network, thereby achieving targeted PAE optimization design, so that a matching degree and fit between the terminal and the existing network are improved, and the power consumption performance of the entire terminal is improved.

### BRIEF DESCRIPTION OF THE DRAWINGS

FIG. 1 is a schematic diagram showing probability distribution of output powers of a power amplifier in a terminal when the terminal is used in the existing network in the related art;
FIG. 2 is a schematic flow chart of a control method according to an embodiment of the present disclosure;
FIG. 3 is a schematic flowchart of a specific implementation of the control method according to an embodiment of the present disclosure;
FIG. 4 is a schematic diagram of a system framework, to which the control method according to an embodiment of the present disclosure is applied;
FIG. 5 is a schematic diagram showing a static operating point of a power amplifier according to an embodiment of the present disclosure;
FIG. 6 is a schematic diagram showing an optimization result of a power added efficiency of a power amplifier according to an embodiment of the present disclosure;
FIG. 7 is a schematic diagram of a control device according to an embodiment of the present disclosure; and
FIG. 8 is a schematic diagram of a terminal according to an embodiment of the present disclosure.

### DETAILED DESCRIPTION

Before introducing technical solutions of embodiments of the present disclosure, related technologies will be described first.

In related art, a power amplifier (PA) is a critical component in an internal radio frequency (RF) communication link of a terminal, and it not only determines a transmission power which is a key functional indicator of the terminal, but also has a crucial impact on power consumption which is a key performance indicator of the terminal.

Terminals have been plagued by power consumption, and how to optimize terminal power consumption has been an issue actively discussed in the industry. As a power amplifier is the "big power consumer" of terminal power consumption, terminal and power amplifier manufacturers have been actively working on optimizing power added efficiency (PAE) of the power amplifier, so as to optimize the power consumption performance of the PA and the terminal.

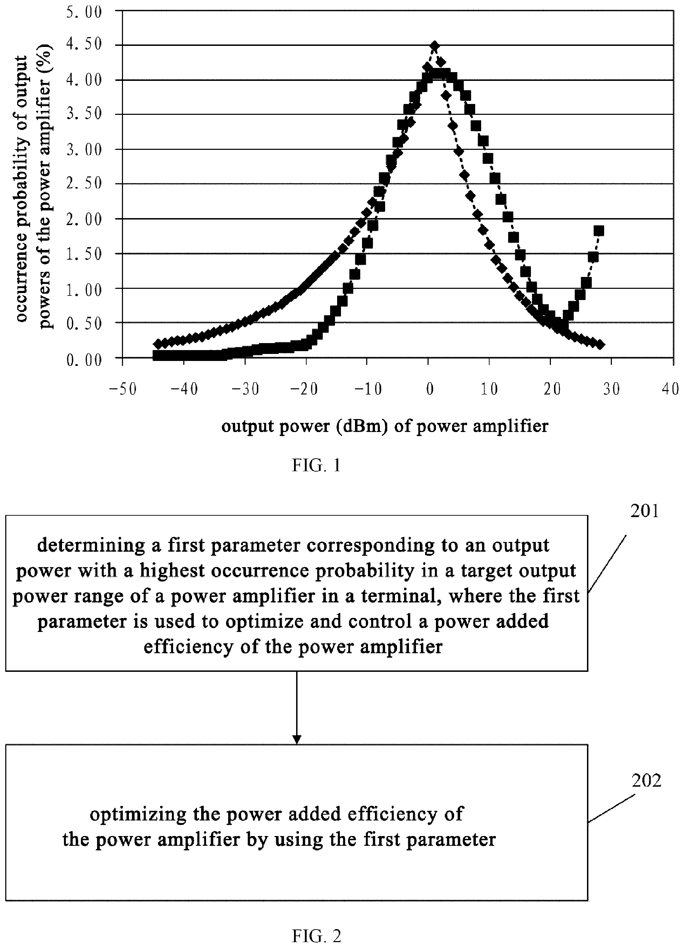

FIG. 1 is a schematic diagram showing probability distribution of output powers of a power amplifier (PA) in a terminal when the terminal is used in the existing network in the related art. As shown in FIG. 1, the horizontal axis represents an output power of the PA, and the vertical axis represents a occurrence probability of the output power of the PA. In related art, PAE optimization is performed for the full power of the PA; since an actual output power of the PA is not necessarily the full power, results of the PAE optimization are relatively poor.

In other words, in the related art, due to inability to timely and accurately determine the probability of different output powers of the PA in the terminal, it is impossible to achieve timely optimization of the PAE based on an output power with the highest probability of the PA.

In view of this, in an embodiment of the present disclosure, a first parameter corresponding to an output power with a highest occurrence probability in a target output power range of a power amplifier in a terminal, is determined, where the first parameter is used to optimize and control a power added efficiency of the power amplifier; and the power added efficiency of the power amplifier is optimized and controlled based on the first parameter.

It is to be noted that for analog circuit design, there are certain dependencies between various design indicators, and there is also a certain dependence between PAEs of different output powers of the PA. The optimization design of PAE for a certain output power of the PA may lead to deterioration of PAE for other output powers of the PA. Thus, under the same set of PA parameter settings, it is only possible to optimize the PAE for a specific output power to achieve a relatively optimal state, but it is impossible to achieve PAE optimization for all output powers of the PA through the same set of PA parameter settings. Therefore, knowing the most common output power of the PA is crucial to improving PAE, and improvement of the PAE is directly related to optimization of the overall power consumption of the terminal.

FIG. 2 is a schematic flow chart of a control method according to an embodiment of the present disclosure, applied to a terminal. As shown in FIG. 2, the method includes steps 201 to 202.

Step 201: determining a first parameter corresponding to an output power with a highest occurrence probability in a target output power range of a power amplifier in a terminal, where the first parameter is used to optimize and control a power added efficiency of the power amplifier.

It can be understood that the output powers of the power amplifier in the terminal is probabilistically distributed in the target output power range, that is, occurrence possibilities of output powers of the power amplifier in the terminal vary greatly.

For example, it is assumed that there is a peak in the probability distribution of the output powers of the power amplifier in the terminal. A target output power range corresponding to the peak is 10dBm to 30dBm. In the target output power range, the occurrence probability of 15dBm is 10%; the occurrence probability of 20dBm is 30%, and the occurrence probability of 26dBm is 60%.

In another example, it is assumed that there are two peaks in the probability distribution of the output powers of the power amplifier in the terminal. A first target output power range corresponding to a first peak is 10dBm to 30dBm, and a second target output power range corresponding to the second peak is 30dBm to 40dBm. It is assumed that the output power corresponding to the highest occurrence probability (i.e., the first peak) in the first target output power range is 26dBm and the output power corresponding to the highest occurrence probability (i.e., the second peak) in the second target output power range is 35dBm; then for 26dBm and 35dBm, a first parameter corresponding to 26dBm and a first parameter corresponding to 35dBm can be determined respectively according to actual needs, or only the first parameter corresponding to 26dBm is determined, or only the first parameter corresponding to 35dBm is determined.

It can be understood that the power added efficiency of the power amplifier is optimized and controlled for the most frequently used output power of the power amplifier in the terminal, i.e., the output power with the highest occurrence probability of the power amplifier, thereby optimizing the power consumption performance of the terminal and achieving the purpose of saving the power consumption of the terminal.

It can be understood that the first parameter may refer to an operating parameter capable of controlling the power amplifier in the terminal to be in an optimal PAE operating state.

The following describes in detail the process of how to determine the first parameter corresponding to an output power with a highest occurrence probability in a target output power range of a power amplifier in a terminal.

In practical applications, considering the different network coverage capabilities in different countries and provinces, output powers with the highest occurrence probability in target output power ranges of power amplifiers in terminals in different countries and provinces are different. Considering that the temperature changes, the output power with the highest occurrence probability in the target output power range of the power amplifier in the terminal may be different at different temperatures. Considering that the operation status of a base station is different in different time periods, the output power with the highest occurrence probability in the target output power range of the power amplifier in the terminal is different at different times. Considering that the deployment situation of the base station is different in the future, the output power with the highest occurrence probability in the target output power range of the power amplifier in the terminal in the future is different. Therefore, at least one of a current location of the terminal, a current ambient temperature of the terminal, a preset time range and a future moment can be combined to determine the first parameter corresponding to the output power with the highest occurrence probability in the target output power range of the power amplifier in the terminal.

Based on this, in one embodiment, determining a first parameter corresponding to an output power with a highest occurrence probability in a target output power range of a power amplifier in a terminal, includes:
determining a second parameter; where the second parameter represents at least one of a current location of the terminal, a current ambient temperature of the terminal, a preset time range, and a future moment;
using the second parameter to determine the first parameter corresponding to the output power with the highest occurrence probability in the target output power range of the power amplifier in the terminal.

It can be understood that the target output power range can be used to count the output power with the highest occurrence probability of the power amplifier in the terminal.

In a first case, the current location of the terminal is used to determine the first parameter corresponding to the output power with the highest occurrence probability in the target output power range of the power amplifier in the terminal.

In practical applications, considering that in different countries and provinces, output powers with the highest occurrence probability in the target output power range of power amplifiers in terminals are different, therefore, an output power probability distribution diagram of the power amplifier in the terminal at a current location of the terminal can be determined first, and the output power with the highest occurrence probability in the target output power range of the power amplifier in the terminal can be determined according to the output power probability distribution diagram; and then, the first parameter corresponding to the output power with the highest probability of the power amplifier can be selected from preset correspondence between output powers and operation parameters.

Based on this, in one embodiment, the second parameter represents the current location of the terminal; the using the second parameter to determine the first parameter corresponding to the output power with the highest occurrence probability in the target output power range of the power amplifier in the terminal, includes:
determining the output power with the highest occurrence probability in the target output power range of the power amplifier in the terminal by using the current location of the terminal represented by the second parameter;
determining the first parameter according to the determined output power.

Specifically, the determining the output power with the highest occurrence probability in the target output power range of the power amplifier in the terminal by using the current location of the terminal represented by the second parameter, includes:
determining an output power probability distribution diagram of the power amplifier in the terminal at a current location of the terminal;
determining the output power with the highest occurrence probability in the target output power range of the power amplifier in the terminal according to the output power probability distribution diagram.

Here, output power probability distribution diagrams of the power amplifier in the terminal determined at different locations are different.

For example, for the same terminal, it is assumed that an output power with the highest occurrence probability of the power amplifier in the terminal in Europe is represented by Pe (dBm) and an output power with the highest occurrence probability of the power amplifier in the terminal in China is represented by Pc (dBm). Since the coverage of the 5th Generation (5G) network in China is denser than that of 5G networks abroad, Pe>Pc. Therefore, in different countries, different operation parameters for PAE optimization of the power amplifier are configured for the output power with the highest probability.

For another example, the network coverage capabilities of different provinces are also different. Therefore, when the same terminal is in different provinces, output power probability distribution diagrams of the power amplifier in the terminal are also different. In this way, in different provinces, different operation parameters for PAE optimization of the power amplifier are configured for the output power with the highest probability.

In a case, the network operator equipment can obtain the output power of the power amplifier in the terminal, and count an occurrence probability of the output power, thereby obtaining an output power probability distribution diagram of the power amplifier in the terminal at the current location of the terminal, and sending the output power probability distribution diagram to the terminal. In this way, the terminal can determine the output power with the highest occurrence probability in the target output power range according to the output power probability distribution diagram, and select the first parameter corresponding to the output power with the highest occurrence probability from the preset correspondence between output powers and operation parameters to optimize the PAE of the power amplifier in the terminal.

In another case, the network operator equipment at the current location of the terminal can obtain an output power of an antenna port of the terminal and count an occurrence probability of the output power, thereby obtaining an output power probability distribution diagram of the antenna port of the terminal at the current location of the terminal and sending the output power probability distribution diagram to the terminal. In this way, the terminal sums the output power of the antenna port of the terminal and an insertion loss from an output port of the power amplifier in the terminal to the antenna port to obtain the output power of the power amplifier in the terminal, thereby obtaining an output power probability distribution diagram of the power amplifier in the terminal at the current location of the terminal. In this way, the terminal can determine the output power with the highest occurrence probability in the target output power range according to the output power probability distribution diagram, and select the first parameter corresponding to the output power with the highest occurrence probability from the preset correspondence between output powers and operation parameters to optimize the PAE of the power amplifier in the terminal.

For example, it is assumed that the insertion loss from the output port of the power amplifier (PA) in the terminal to the antenna port of the terminal is L (dBm). If an output power with the highest probability (X%) of the terminal under an existing network is P1 (dBm), then an output power with the highest probability (X%) of the power amplifier (PA) in the terminal operating under the same existing network is Pl+L (dBm). Therefore, PAE optimization needs to be performed for the output power of the power amplifier, that is, P1+L (dBm).

It is to be noted that configuration of the first parameter can be stored in the terminal in advance. In this way, after determining the first parameter corresponding to the output power with the highest occurrence probability in the target output power range of the power amplifier in the terminal, the configuration of the first parameter can be obtained from the local and be used to optimize the power added efficiency of the power amplifier.

In actual application, the network side server can determine the output power probability distribution diagram of the power amplifier in the terminal at the current location of the terminal, and determine the output power with the highest occurrence probability in the target output power range of the power amplifier in the terminal according to the output power probability distribution diagram, and select the first parameter corresponding to the output power with the highest occurrence probability from the preset correspondence between output powers and operation parameters, and send the first parameter to the terminal.

Based on this, in one embodiment, the second parameter represents the current location of the terminal; the using the second parameter to determine the first parameter corresponding to the output power with the highest occurrence probability in the target output power range of the power amplifier in the terminal, includes:
transmitting a current location of the terminal represented by the second parameter to the first server, where the current location of the terminal is used for the first server to determine the first parameter corresponding to the output power with the highest occurrence probability in the target output power range of the power amplifier in the terminal;
receiving the first parameter transmitted by the first server.

It is to be noted that configuration of the first parameter can be stored in the first server on the network side in advance. In this way, after determining the first parameter corresponding to the output power with the highest occurrence probability in the target output power range of the power amplifier in the terminal, the first server on the network side can transmit the first parameter to the terminal, so that the terminal uses the first parameter to optimize the power added efficiency of the power amplifier. Since the first parameter is not stored locally in the terminal, the storage space of the terminal can be saved.

In actual application, a remote server can determine an output power probability distribution diagram of the power amplifier in the terminal at the current location of the terminal, and determine the output power with the highest occurrence probability in the target output power range of the power amplifier in the terminal according to the output power probability distribution diagram, and select the first parameter corresponding to the output power with the highest occurrence probability from the preset correspondence between the output powers and operation parameters, and indicate the first parameter to the terminal.

Based on this, in one embodiment, the second parameter represents the current location of the terminal; the using the second parameter to determine the first parameter corresponding to the output power with the highest occurrence probability in the target output power range of the power amplifier in the terminal, includes:
transmitting the current location of the terminal represented by the second parameter to a second server, where the current location of the terminal is used for the second server to determine the first parameter corresponding to the output power with the highest occurrence probability in the target output power range of the power amplifier in the terminal;
receiving indication information transmitted by the second server; where the indication information is used to indicate the first parameter;
determining the first parameter according to the indication information.

It is to understood that the indication information may carry an index of the first parameter.

That is to say, the configuration of the first parameter may be stored in the terminal. After receiving the indication information transmitted by the second server, the terminal can obtain the configuration of the first parameter locally based on the index of the first parameter.

It is to be noted that the configuration of the first parameter may be stored in the terminal, so that after the remote second server determines the first parameter corresponding to the output power with the highest occurrence probability in the target output power range of the power amplifier in the terminal, the remote second server can indicate the first parameter to the terminal. The terminal obtains the configuration of the first parameter locally according to the indication information, and uses the first parameter to optimize the power added efficiency of the power amplifier. Since the second server indicates the first parameter to be used by the terminal through the indication information, the signaling overhead is relatively small, so the bit overhead occupied by the transmission can be saved.

In a second case, the current ambient temperature of the terminal is used to determine the first parameter corresponding to the output power with the highest occurrence probability in the target output power range of the power amplifier in the terminal.

In practical applications, an output power probability distribution diagram of the power amplifier in the terminal under the current ambient temperature can be determined. In this way, an output power with the highest occurrence probability in the target output power range of the power amplifier in the terminal can be determined based on the output power probability distribution diagram.

Based on this, in one embodiment, the second parameter represents a current ambient temperature of the terminal; the using the second parameter to determine the first parameter corresponding to the output power with the highest occurrence probability in the target output power range of the power amplifier in the terminal, includes:
determining the output power with the highest occurrence probability in the target output power range of the power amplifier in the terminal by using the current ambient temperature of the terminal represented by the second parameter;
determining the first parameter according to the determined output power.

Specifically, the determining the output power with the highest occurrence probability in the target output power range of the power amplifier in the terminal by using the current ambient temperature of the terminal represented by the second parameter, includes:
determining an output power probability distribution diagram of the power amplifier in the terminal at a current ambient temperature of the terminal;
determining the output power with the highest occurrence probability in the target output power range of the power amplifier in the terminal according to the output power probability distribution diagram.

Here, output power probability distribution diagrams of the power amplifier in the terminal determined at different temperatures are different.

In a case, the network operator equipment can obtain the output power of the power amplifier in the terminal, and count an occurrence probability of the output power, thereby obtaining an output power probability distribution diagram of the power amplifier in the terminal at the current ambient temperature of the terminal, and sending the output power probability distribution diagram to the terminal. In this way, the terminal can determine the output power with the highest occurrence probability in the target output power range according to the output power probability distribution diagram, and select the first parameter corresponding to the output power with the highest occurrence probability from the preset correspondence between output powers and operation parameters to optimize the PAE of the power amplifier in the terminal.

In another case, the network operator equipment can obtain an output power of an antenna port of the terminal and count an occurrence probability of the output power, thereby obtaining an output power probability distribution diagram of the antenna port of the terminal at the current ambient temperature of the terminal and sending the output power probability distribution diagram to the terminal. In this way, the terminal sums the output power of the antenna port of the terminal and an insertion loss from an output port of the power amplifier in the terminal to the antenna port to obtain the output power of the power amplifier in the terminal, thereby obtaining an output power probability distribution diagram of the power amplifier in the terminal. In this way, the terminal can determine the output power with the highest occurrence probability in the target output power range according to the output power probability distribution diagram, and select the first parameter corresponding to the output power with the highest occurrence probability from the preset correspondence between output powers and operation parameters to optimize the PAE of the power amplifier in the terminal.

It is to be noted that if the terminal is located in a low-temperature operation environment such as the North and South Pole all year round, the terminal can configure the power amplifier with a set of operation parameters that are more suitable for improving PAE in the low-temperature operation environment; if the terminal is located in a high-temperature operation environment such as the equatorial region all year round, the terminal can configure the power amplifier with a set of operation parameters that are more suitable for improving PAE in the high-temperature operation environment.

In a third case, the preset time range is used to determine the first parameter corresponding to the output power with the highest occurrence probability in the target output power range of the power amplifier in the terminal.

In practical applications, an output power probability distribution diagram of the power amplifier in the terminal in the preset time range can be determined. In this way, the output power with the highest occurrence probability in the target output power range of the power amplifier in the terminal can be determined according to the output power probability distribution diagram.

Based on this, in one embodiment, the second parameter represents a preset time range; the using the second parameter to determine the first parameter corresponding to the output power with the highest occurrence probability in the target output power range of the power amplifier in the terminal, includes:
determining the output power with the highest occurrence probability in the target output power range of the power amplifier in the terminal by using the preset time range represented by the second parameter;
determining the first parameter according to the determined output power.

Specifically, the determining the output power with the highest occurrence probability in the target output power range of the power amplifier in the terminal by using the preset time range represented by the second parameter, includes:
determining an output power probability distribution diagram of the power amplifier in the terminal in the preset time range;
determining the output power with the highest occurrence probability in the target output power range of the power amplifier in the terminal according to the output power probability distribution diagram.

Here, the output power probability distribution diagrams of the power amplifier in the terminal in different time ranges are different. For example, an output power probability distribution diagram of the power amplifier in the terminal between 8 and 9 o'clock in the daytime is different from an output power probability distribution diagram of the power amplifier in the terminal between 8 and 9 o'clock at night.

In a case, the network operator equipment can obtain the output power of the power amplifier in the terminal, and count an occurrence probability of the output power, thereby obtaining an output power probability distribution diagram of the power amplifier in the terminal in the preset time range, and sending the output power probability distribution diagram to the terminal. In this way, the terminal can determine the output power with the highest occurrence probability in the target output power range according to the output power probability distribution diagram, and select the first parameter corresponding to the output power with the highest occurrence probability from the preset correspondence between output powers and operation parameters to optimize the PAE of the power amplifier in the terminal.

In another case, the network operator equipment can obtain an output power of an antenna port of the terminal and count an occurrence probability of the output power, thereby obtaining an output power probability distribution diagram of the antenna port of the terminal in the preset time range and sending the output power probability distribution diagram to the terminal. In this way, the terminal sums the output power of the antenna port of the terminal and an insertion loss from an output port of the power amplifier in the terminal to the antenna port to obtain the output power of the power amplifier in the terminal, thereby obtaining an output power probability distribution diagram of the power amplifier in the terminal in the preset time range. In this way, the terminal can determine the output power with the highest occurrence probability in the target output power range according to the output power probability distribution diagram, and select the first parameter corresponding to the output power with the highest occurrence probability from the preset correspondence between output powers and operation parameters to optimize the PAE of the power amplifier in the terminal.

It is to be noted that if the terminal operates during the day but does not operate at night, the terminal can configure the power amplifier with a set of operation parameters that are more suitable for improving PAE during the day; if the terminal does not operate during the day but operates at night, the terminal can configure the power amplifier with a set of operating parameters that are more suitable for improving PAE at night.

In a fourth case, the future moment is used to determine the first parameter corresponding to the output power with the highest occurrence probability in the target output power range of the power amplifier in the terminal.

In practical applications, an output power probability distribution diagram of the power amplifier in the terminal at a future moment can be determined. In this way, the output power with the highest occurrence probability in the target output power range of the power amplifier in the terminal can be determined based on the output power probability distribution diagram.

Based on this, in one embodiment, the second parameter represents a future moment; the using the second parameter to determine the first parameter corresponding to the output power with the highest occurrence probability in the target output power range of the power amplifier in the terminal, includes:
determining the output power with the highest occurrence probability in the target output power range of the power amplifier in the terminal by using the future moment represented by the second parameter;
determining the first parameter according to the determined output power.

Specifically, the determining the output power with the highest occurrence probability in the target output power range of the power amplifier in the terminal by using the future moment represented by the second parameter, includes:
determining an output power probability distribution diagram of the power amplifier in the terminal at a future moment;
determining the output power with the highest occurrence probability in the target output power range of the power amplifier in the terminal according to the output power probability distribution diagram.

In a case, the network operator equipment can capture output powers of the power amplifier in the terminal at different moments and combine it with a preset network model to predict an output power probability distribution diagram of the power amplifier in the terminal at future moments and send the output power probability distribution diagram to the terminal. In this way, the terminal can determine the output power with the highest occurrence probability in the target output power range based on the output power probability distribution diagram of the power amplifier in the terminal at future moments.

In another case, the network operator equipment can capture output powers of an antenna port of the terminal at different moments and combine it with a preset network model to predict an output power probability distribution diagram of the antenna port of the terminal at future moments and send the output power probability distribution diagram to the terminal. In this way, the terminal sums the output power of the antenna port of the terminal and an insertion loss from an output port of the power amplifier in the terminal to the antenna port to obtain the output power of the power amplifier in the terminal, thereby obtaining an output power probability distribution diagram of the power amplifier in the terminal at the future moments. In this way, the terminal can determine the output power with the highest occurrence probability in the target output power range according to the output power probability distribution diagram.

Specifically, the determining the output power with the highest occurrence probability in the target output power range of the power amplifier in the terminal by using the future moment represented by the second parameter, includes:
receiving the output power probability distribution diagram of the power amplifier in the terminal at future moments determined and transmitted by the network equipment;
determining the output power with the highest occurrence probability in the target output power range of the power amplifier in the terminal according to the output power probability distribution diagram.

It is to be noted that network coverage is not static even in the same area. In the process of evolving from the early stage of a certain communication standard (such as 5G) to the mature stage, the network coverage of this communication standard will continue to increase, and the output power of the terminal with the highest occurrence probability under this communication standard may continue to decrease. As more and more base stations are deployed in the future, the terminal can configure the power amplifier with a set of operation parameters that are more suitable for improving PAE in the future.

Similarly, in the process of a certain communication standard being gradually withdrawn from the network, the network coverage of this communication standard will continue to weaken, and the output power of the terminal with the highest occurrence probability under this communication standard may continue to increase.

In a fifth case, at least one of the current location of the terminal, the current ambient temperature of the terminal, the preset time range and the future moment is used to determine the first parameter corresponding to the output power with the highest occurrence probability in the target output power range of the power amplifier in the terminal.

For example, an output power probability distribution diagram of the power amplifier in the terminal under the current location of the terminal and the current ambient temperature can be determined; an output power with the highest occurrence probability in the target output power range can be determined based on the determined output power probability distribution diagram, and a set of operation parameters, which is more suitable for improving PAE, is configured for the power amplifier;
Or,
an output power probability distribution diagram of the power amplifier in the terminal under the current location of the terminal and the current ambient temperature as well as the preset time range, can be determined; an output power with the highest occurrence probability in the target output power range can be determined based on the determined output power probability distribution diagram, and a set of operation parameters, which is more suitable for improving PAE, is configured for the power amplifier;

In a sixth case, considering that the terminal is within coverage of a first network equipment, that is to say, the terminal and the first network equipment have the same location, ambient temperature and time, in this way, the terminal can also transmit a power headroom report to the first network equipment for the first network equipment to determine the output power with the highest occurrence probability of the power amplifier in the terminal. The first network equipment may send the determined output power to a first electronic device, and the first electronic device sends the determined output power to the terminal.

Based on this, in one embodiment, the determining the first parameter corresponding to the output power with the highest occurrence probability in the target output power range of the power amplifier in the terminal, includes:
determining a power headroom report; where the power headroom report carries first information and second information, the first information represents a difference between a terminal's maximum allowable transmission power and a currently evaluated transmission power of the physical uplink shared channel, and the second information represents a terminal's maximum allowable transmission power on a current carrier at a current serving cell;
transmitting the power headroom report to the first network equipment; where the power headroom report is used for the first network equipment to parse to obtain the first information and the second information and send the first information and the second information to the first electronic device; the first information and the second information are used for the first electronic device to determine the output power with the highest occurrence probability in the target output power range of the power amplifier in the terminal in at least one of the following situations:
   at a location of the first network equipment;
   at an ambient temperature of the first network equipment;
   in a preset time range;
   in future moment;
   receiving the output power sent by the first electronic device;
   determining a first parameter based on the output power.

The first network equipment may specifically refer to a base station; and the first electronic device may be a separate device different from the first network equipment, or may be integrated into the first network equipment.

It can be understood that the first information may specifically refer to power headroom (PH) information; the second information may specifically refer to P_{CMAX} information.

PH is a difference between a terminal's maximum allowable transmission power and a currently evaluated physical uplink shared channel (PUSCH) transmission power, and it indicates how much transmission power the terminal can use in addition to the transmission power currently used for PUSCH transmission, which can be simply expressed with a formula: PH=AllowedMaxTransPower-PuschPower, where AllowedMaxTransPower represents a terminal's maximum allowable transmission power, and PuschPower represents a currently evaluated PUSCH transmission power.

P_{CMAX} is the maximum allowable transmission power configured for the terminal on a current carrier at a current serving cell, and the P_{CMAX} has taken into account the power rollback caused by various influencing factors, such as maximum power reduction (MPR). It is to be noted that the above AllowedMaxTransPower is P_{CMAX}.

It can be understood that the first network equipment can send, to the first electronic device, the first information, the second information, the location of the first network equipment, the ambient temperature of the first network equipment, the preset time range and the future moment obtained by parsing power headroom reports reported by a large number of terminals. In this way, the first electronic device can first calculate real-time transmission power of PUSCH of a large number of terminals based on the first information and the second information. Then, the first electronic device can select the real-time transmission power of PUSCH of the terminal that matches at least one of the location of the first network equipment, the ambient temperature of the first network equipment, a preset time range, and a future moment. After that, the first electronic device can count corresponding probabilities for the real-time transmission power of PUSCH of the selected terminal, thereby obtaining an probability distribution diagram of different output powers of the terminal; the first electronic device sums the real-time transmission power of PUSCH of the terminal and insertion loss from an output port of the power amplifier to the antenna port in the terminal, thereby obtaining output power probabilities of the power amplifier in the terminal and then obtaining an output power probability distribution diagram of the power amplifier in the terminal. Finally, based on the obtained output power probability distribution diagram of the power amplifier in the terminal, an output power with the highest occurrence probability in the target output power range is determined.

It can be understood that, after receiving the power headroom report sent by the terminal, the first network equipment can obtain the P_{CMAX} and PH carried in the power headroom report by parsing the power headroom report and send the P_{CMAX} and PH to the first electronic device. The first electronic device obtains the real-time transmission power of PUSCH of the current terminal by calculating a difference between P_{CMAX} and PH.

Further, the first network equipment can also obtain a power headroom report sent by other terminal, and can obtain P_{CMAX} and PH carried in the power headroom report by parsing the power headroom report and send the P_{CMAX} and PH to the first electronic device. The electronic device obtains a real-time transmission power of PUSCH of the other terminal by calculating a difference between P_{CMAX} and PH.

In this way, after obtaining the real-time transmission powers of PUSCHs of a large number of terminals, the first electronic device first selects the real-time transmission power of PUSCHs of a terminal that meets the conditions, and counts corresponding probabilities to obtain an output power probability distribution diagram of the terminal. Then, the real-time transmission power of PUSCH of the terminal and the insertion loss from the output port of the power amplifier in the terminal to the antenna port are summed to obtain an output power probability of the power amplifier in the terminal, thereby obtaining an output power probability distribution diagram of the power amplifier in the terminal. Finally, based on the obtained output power probability distribution diagram of the power amplifier in the terminal, the output power with the highest occurrence probability in the target output power range is determined.

For example, it is assumed that the first network equipment is located in a city A, the first network equipment obtains power headroom reports reported by a large number of terminals in the city A, parses the power headroom reports to obtain P_{CMAX} and PH, and sends the P_{CMAX} and PH to a first electronic device. The first electronic device obtains real-time transmission powers of PUSCH of the terminals by calculating a difference between P_{CMAX} and PH, and counts corresponding probability to obtain output power probability distribution diagrams of the terminals;
or,
it is assumed that the ambient temperature of the first network equipment is July-August in summer, the first network equipment obtains power headroom reports reported by terminals in July-August in summer, parses the power headroom reports to obtain P_{CMAX} and PH, and sends the P_{CMAX} and PH to a first electronic device. The first electronic device obtains real-time transmission powers of PUSCH of the terminals by calculating a difference between P_{CMAX} and PH, and counts corresponding probability to obtain output power probability distribution diagrams of the terminals in a time range of July to August in summer;
   or,
it is assumed that the preset time range is 12:00-13:00 during the day, the first network equipment obtains power headroom reports reported by terminals between 12:00-13:00 during the day, parses the power headroom reports to obtain P_{CMAX} and PH, and sends the P_{CMAX} and PH to a first electronic device. The first electronic device obtains real-time transmission powers of PUSCH of the terminals by calculating a difference between P_{CMAX} and PH, and counts corresponding probability to obtain output power probability distribution diagrams of the terminals in a time range of 12:00-13:00 during the day;
   or,
the first network equipment obtains power headroom reports reported by a large number of terminals at different times of a day, parses the power headroom reports to obtain P_{CMAX} and PH, and sends the P_{CMAX} and PH to a first electronic device. The first electronic device obtains real-time transmission powers of PUSCH of the terminals by calculating a difference between P_{CMAX} and PH; based on the network model, an output power probability distribution diagram of the terminal at a certain time in the future is inferred.

It is to be noted that the specific mods of receiving the output power with the highest occurrence probability sent by the first electronic device may include: a first mode of directly receiving the output power with the highest occurrence probability sent by the first electronic device; a second mode of receiving the output power with the highest occurrence probability sent by the first electronic device through indication information.

It is to be noted that in order to ensure quality of radio frequency indicators transmitted by terminals in different modulation modes and frequency domain positions and to meet requirements of electromagnetic radiation absorption ratio in certain scenarios, MPR and additional maximum power reduction (A-MPR) are defined to guide the terminal to perform appropriate power rollback.

It is to be noted that the terminal sends a power headroom report to the network equipment, so that the network equipment can accurately control the power of PUSCH to ensure the user service experience. Value of the power headroom (PH) is transmitted through Media Access Control (MAC) control element. The MAC CE related to this process is also referred as a power headroom reporting control element.

In a seventh case, the terminal may also receive the first parameter directly transmitted by a second electronic device.

Based on this, in one embodiment, the determining the first parameter corresponding to the output power with the highest occurrence probability in the target output power range of the power amplifier in the terminal, includes:
receiving the first parameter transmitted by the second electronic device; where the first parameter is an operation parameter corresponding to an output power with the highest occurrence probability in the target output power range of the power amplifier in the terminal, and the output power with the highest occurrence probability in the target output power range of the power amplifier in the terminal is determined by the second electronic device according to an output power probability distribution diagram of the power amplifier in the terminal obtained in at least one of the following situations:
at a location of the first network equipment;
at an ambient temperature of the first network equipment;
in a preset time range;
in future moments.

It is to be noted that, considering that the terminal is within the coverage of the first network equipment, that is, the terminal and the first network equipment have the same location, ambient temperature and time, in this way, the second electronic device can first obtain a location of the first network equipment, an ambient temperature of the first network equipment, a preset time range, a future moment, the first information and the second information transmitted by the first network equipment. Then, the second electronic device can use the first information and the second information to obtain an output power probability distribution diagram of the power amplifier in the terminal in at least one of the above situations, and determines the output power with the highest occurrence probability in the target output power range of the power amplifier in the terminal according to the obtained output power probability distribution diagram of the power amplifier in the terminal. Afterwards, the second electronic device selects a first parameter corresponding to the output power with the highest occurrence probability of the power amplifier from corresponding relationship between output powers and operation parameters. Finally, the second electronic device transmits a detected first parameter or a code representing the first parameter to the terminal.

In an eighth case, the terminal may also obtain the first parameter locally.

Based on this, in one embodiment, the determining the first parameter corresponding to the output power with the highest occurrence probability in the target output power range of the power amplifier in the terminal, includes:
obtaining the first parameter from the terminal locally; where the first parameter is pre-written into the terminal by a third electronic device; the first parameter is an operation parameter corresponding to an output power with the highest occurrence probability in the target output power range of the power amplifier in the terminal, and the output power with the highest occurrence probability in the target output power range of the power amplifier in the terminal is determined by the third electronic device according to an output power probability distribution diagram of the power amplifier in the terminal obtained in at least one of the following situations:
at a location of the first network equipment;
at an ambient temperature of the first network equipment;
in a preset time range;
in future moments;
   or,
obtaining the first parameter from the terminal locally; where the first parameter is pre-written into the terminal by a fourth electronic device; the first parameter is an operation parameter, which is determined by the fourth electronic device and is corresponding to an output power with the highest occurrence probability in the target output power range of the power amplifier in the terminal; and the output power with the highest occurrence probability in the target output power range of the power amplifier in the terminal is transmitted from the third electronic device to the fourth electronic device; and the output power with the highest occurrence probability in the target output power range of the power amplifier in the terminal is determined by the third electronic device according to an output power probability distribution diagram of the power amplifier in the terminal obtained in at least one of the following situations:
   at a location of the first network equipment;
   at an ambient temperature of the first network equipment;
   in a preset time range;
   in future moments;
      or,
   obtaining the first parameter from the terminal locally; where the first parameter is pre-written into the terminal by a fifth electronic device; the first parameter is an operation parameter, which is determined by the fourth electronic device and is corresponding to an output power with the highest occurrence probability in the target output power range of the power amplifier in the terminal; the first parameter is transmitted from the fourth electronic device to the fifth electronic device; and the output power with the highest occurrence probability in the target output power range of the power amplifier in the terminal is transmitted from the third electronic device to the fourth electronic device; and the output power with the highest occurrence probability in the target output power range of the power amplifier in the terminal is determined by the third electronic device according to an output power probability distribution diagram of the power amplifier in the terminal obtained in at least one of the following situations:
      at a location of the first network equipment;
      at an ambient temperature of the first network equipment;
      in a preset time range;
      in future moments.

It is to be noted that, considering that the terminal is within the coverage of the first network equipment, that is, the terminal and the first network equipment have the same location, ambient temperature and time, in this way, the third electronic device can obtain a location of the first network equipment, an ambient temperature of the first network equipment, a preset time range, a future moment, the first information and the second information transmitted by the first network equipment. Then, the third electronic device can use the first information and the second information to obtain an output power probability distribution diagram of the power amplifier in the terminal in at least one of the above situations, and determines the output power with the highest occurrence probability in the target output power range of the power amplifier in the terminal according to the obtained output power probability distribution diagram of the power amplifier in the terminal. Afterwards, the third electronic device selects a first parameter corresponding to the output power with the highest occurrence probability of the power amplifier from corresponding relationship between output powers and operation parameters. Before the terminal leaves the factory, the first parameter is directly written into the terminal, so that the terminal can obtain the first parameter locally.

It is to be noted that, considering that the terminal is within the coverage of the first network equipment, that is, the terminal and the first network equipment have the same location, ambient temperature and time, in this way, the third electronic device can obtain a location of the first network equipment, an ambient temperature of the first network equipment, a preset time range, a future moment, the first information and the second information transmitted by the first network equipment. Then, the third electronic device can use the first information and the second information to obtain an output power probability distribution diagram of the power amplifier in the terminal in at least one of the above situations, and determines the output power with the highest occurrence probability in the target output power range of the power amplifier in the terminal according to the obtained output power probability distribution diagram of the power amplifier in the terminal. Afterwards, the third electronic device transmits the determined output power with the highest occurrence probability to the fourth electronic device. The fourth electronic device selects a first parameter corresponding to the output power with the highest occurrence probability of the power amplifier from corresponding relationship between output powers and operation parameters. Before the terminal leaves the factory, the fourth electronic device directly writes the first parameter into the terminal, so that the terminal can obtain the first parameter locally.

It is to be noted that, considering that the terminal is within the coverage of the first network equipment, that is, the terminal and the first network equipment have the same location, ambient temperature and time, in this way, the third electronic device can obtain a location of the first network equipment, an ambient temperature of the first network equipment, a preset time range, a future moment, the first information and the second information transmitted by the first network equipment. Then, the third electronic device can use the first information and the second information to obtain an output power probability distribution diagram of the power amplifier in the terminal in at least one of the above situations, and determines the output power with the highest occurrence probability in the target output power range of the power amplifier in the terminal according to the obtained output power probability distribution diagram of the power amplifier in the terminal. Afterwards, the third electronic device transmits the determined output power with the highest occurrence probability to the fourth electronic device. The fourth electronic device selects a first parameter corresponding to the output power with the highest occurrence probability of the power amplifier from corresponding relationship between output powers and operation parameters, and transmits the first parameter to the fifth electronic device. Before the terminal leaves the factory, the fifth electronic device directly writes the first parameter into the terminal, so that the terminal can obtain the first parameter locally.

In practical applications, it is taken into account that the output power with the highest occurrence probability in the target output power range of the power amplifier in the terminal is different in different situations. For example, taking the location of the terminal as an example, an output power with the highest occurrence probability determined at a location A of the terminal may be different from an output power with the highest occurrence probability determined at a location B of the terminal. However, in order to be able to use the same first parameter to optimize the PAE of the power amplifier in the terminal at the locations A and B of the terminal, the two output powers with the highest probability can form a first output power range, and then a first parameter corresponding to the first output power range is searched from a preset correspondence between output powers and operation parameters. In this way, the PAE of the power amplifier in the terminal can be optimized by using the found first parameter at both the locations A and B of the terminal.

Based on this, in one embodiment, output powers with the highest occurrence probability in the target output power range of the power amplifier form N first-output power ranges, and each first output power range includes M output powers; where N, M are positive integers;
where each first output power range includes the same or different amounts of output powers.

Specifically, it is assumed that output powers with the highest occurrence probability in the target output power range of the power amplifier in the terminal form two first-output power ranges, where the first first-output power range includes M1 output powers, and the second first-output power range includes M2 output powers. M1 may be equal to M2, or M1 may not be equal to M2.

It can be understood that when network coverage capabilities within an area where the terminal is located are inconsistent, it may cause that output powers with the highest occurrence probability in the target output power range of the power amplifier form multiple first-output power ranges.

For example, it is assumed that the terminal is located in China, and output powers of the power amplifier in the terminal are captured in cities A, B, and C in China, respectively. The network coverage capabilities of the three cities are inconsistent. The output powers with the highest occurrence probability in the target output power range of the power amplifier obtained in the three cities can form multiple first-output power ranges. For example, an output power with the highest probability corresponding to an area 1 of the city A is 15dBm, an output power with the highest probability corresponding to an area 2 of the city A is 20dBm, and then a first-output power range corresponding to the city A can be represented by a set {15dBm, 20dBm}; an output power with the highest probability corresponding to an area 1 of the city B is 26dBm, an output power with the highest probability corresponding to an area 2 of the city B is 30dBm, and then a first-output power range corresponding to the city B can be represented by a set {26dBm, 30dBm}; an output power with the highest probability corresponding to an area 1 of the city C is 18dBm, an output power with the highest probability corresponding to an area 2 of the city B is 25dBm, and then a first-output power range corresponding to the city C can be represented by a set {18dBm, 25dBm}.

Further, first parameters corresponding to the three first-output power ranges are respectively searched from preset correspondence between output power ranges and operation parameters. If the found first parameters are all the same, then in the city A, the city B and the city C, the same first parameter is used to perform PAE optimization for the power amplifier in the terminal. If the found first parameters are all different, then in the city A, the city B and the city C, different first parameters can be used to perform PAE optimization for the power amplifier in the terminal, or the first parameter corresponding to one of the cities can be used to perform PAE optimization for the power amplifier in the terminal.

Further, a first parameter corresponding to an output power with the highest probability in an area 1 of the city A and a first parameter corresponding to an output power with the highest probability in an area 2 of the city A may be searched from preset correspondence between output power ranges and operation parameters. If the found first parameters are all the same, then in the area 1 and the area 2 of the city A, the same first parameter is used to perform PAE optimization for the power amplifier in the terminal. If the found first parameters are all different, then in the area 1 and the area 2 of the city A, different first parameters can be used to perform PAE optimization for the power amplifier in the terminal, or the first parameter corresponding to one of the areas can be used to perform PAE optimization for the power amplifier in the terminal.

In one case, when output powers with the highest probability in the existing network of the power amplifier in the terminal forms N (N ≥ 1) output power ranges, a set of operation parameter configurations for PAE optimization can be given for these N output power ranges.

It is to be noted that when the terminal moves from a certain position to another position, first-output power ranges formed by the output powers with the highest occurrence probability of the power amplifier may be different, and if first parameters corresponding to the two first-output power ranges are the same, the same operation parameters may be used for PAE optimization without changing the operation parameter configuration, thereby improving convenience of PAE optimization.

It is to be noted that when the terminal moves from a certain position to another position, output powers with the highest occurrence probability of the power amplifier may be different, if the two output powers belong to the same output power range, the same operation parameters can be used for PAE optimization without changing the operation parameter configuration, thereby improving convenience of PAE optimization.

In another case, when output powers with the highest probability in the existing network of the power amplifier in the terminal forms N (N ≥ 1) output power ranges, N sets of operation parameter configurations for PAE optimization can be given for these corresponding N output power ranges.

It is to be noted that if one set of operation parameter configurations is determined for one output power range, N sets of operation parameter configurations will be obtained for N output power ranges, and values of N PAEs optimized by using the obtained N sets of operation parameter configurations are higher and have better effect.

Step 202: optimizing the power added efficiency of the power amplifier by using the first parameter.

Specifically, the first parameter can be used to adjust a static operation point of the power amplifier in the terminal, thereby controlling the power amplifier to be in a PAE-optimal operation state at the output power with the highest probability.

When the static operation point Q is set too high, saturation distortion will occur. By taking a transistor as an example, the first parameters include a collector voltage U_{CE}, an amplification factor β, a collector current Ic, a collector resistance Rc and other parameters. When the Q point is too high, although a dynamic current of a base electrode is an undistorted sine wave, the transistor enters a saturation region (I_{C}=βI_{B}) during a period of time near a peak value of a positive half cycle of an input signal, resulting in top distortion of a dynamic current of the collector, that is, a collector voltage (U_{CE}=V_{CC}-βI_{C}R_{C}) produces bottom distortion. Similarly, when the static operation point Q is set too low, cutoff distortion will occur. By taking the transistor as an example, when the Q point is too low, the transistor enters a cut-off region, causing the dynamic current of the collector to produce bottom distortion, that is, the collector voltage (U_{CE}=V_{CC}-βI_{C}R_{C}) produces top distortion. Therefore, an appropriate static operation point Q can be set through the first parameter. Further, metal-oxide-semiconductor field-effect transistor (MOSFET) and the transistor have the same operation characteristics. When the power amplifier in the terminal needs to output the highest power, more attention must be paid to preventing saturation distortion, so a relatively low static operation point needs to be selected; and when the power amplifier in the terminal needs to output a smaller power, the static operation point can be set in a wider range, and there is a greater probability of selecting a static operation point with higher operation efficiency.

The embodiments of the present disclosure have the following advantages:
(1) PAE optimization is performed for the output power with the highest probability of the power amplifier in the terminal in the existing network, thereby achieving targeted PAE optimization design, so that a matching degree and fit between the terminal and the existing network are improved, and the power consumption performance of the entire terminal is improved;
(2) Optimize the design of PAE are performed for the output power with the highest probability of the power amplifier in the terminal in the existing network, the same output power can be obtained with less power consumption, thereby saving power consumption of the terminal.

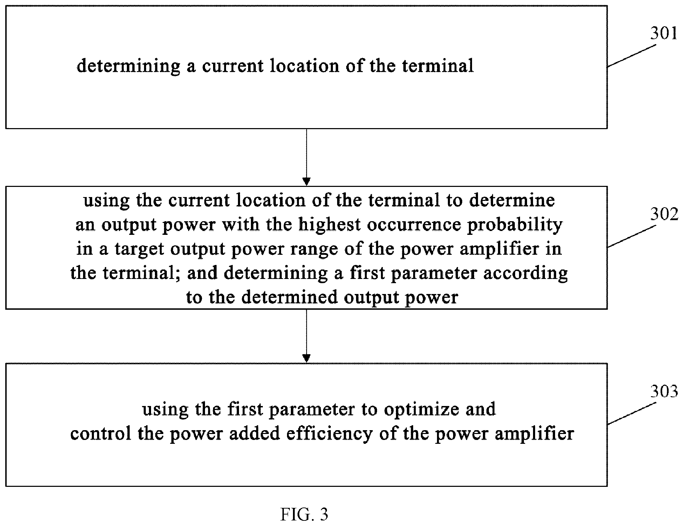

FIG. 3 is a schematic flowchart of a specific implementation of the control method according to an embodiment of the present disclosure. As shown in FIG. 3, the method is applied to a terminal, and includes steps 301 to 303.

Step 301: determining a current location of the terminal.

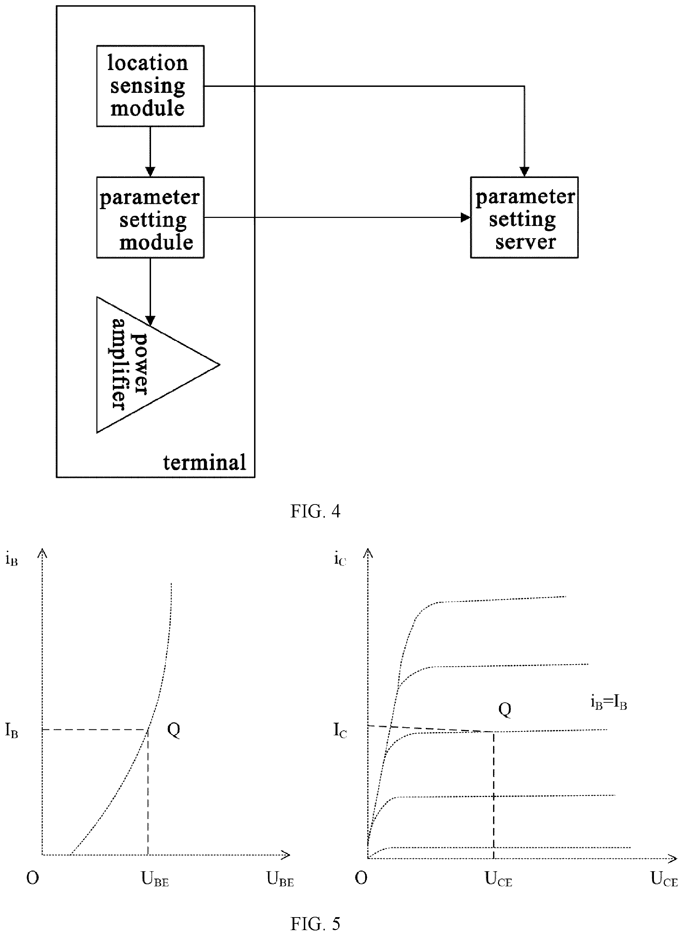

FIG. 4 is a schematic diagram of a system framework, to which the control method is applied. As shown in FIG. 4, the system includes a terminal and a parameter setting server. The terminal is provided with a location sensing module, a parameter setting module and a power amplifier.

Here, considering the highly mobile terminal, the current location of the terminal can be obtained through the location sensing module inside the terminal.

Step 302: using the current location of the terminal to determine an output power with the highest occurrence probability in a target output power range of the power amplifier in the terminal; and determining a first parameter according to the determined output power.

Here, output powers with the highest occurrence probability in the target output power range of the power amplifier in the terminal forms N first-output power ranges, and each first-output power range includes M output powers; where N and M are both positive integers.

Here, for the N first-output power ranges, N operation parameter configurations for PAE optimization are determined, that is, N first parameter configurations.

In a first case, the N first parameter configurations are pre-stored in the parameter setting module of the terminal before leaving the factory.

Specifically, the location sensing module in the terminal senses the current location of the terminal and sends the current location of the terminal to the parameter setting module. The parameter setting module in the terminal determines an output power with the highest occurrence probability in a target output power range of the power amplifier in the terminal according to the current location of the terminal and selects a first parameter suitable for the output power with the highest probability from the preset correspondence between output powers and operation parameters and configures the first parameter to the power amplifier, thereby controlling the operation state of the power amplifier and then improving PAE optimization.

In a second case, a parameter setting server on the network side delivers the N first parameter configurations to the terminal in real time.

Specifically, the location sensing module in the terminal senses the current location of the terminal, and reports the current location of the terminal to the parameter setting server on the network side. The parameter setting server determines an output power with the highest probability in the target output power range of the power amplifier in the terminal based on the current location of the terminal, and selects a first parameter suitable for the output power with the highest probability from the preset correspondence between output powers and operation parameters and sends the first parameter to the terminal. The parameter setting module in the terminal configures the received first parameter to the power amplifier, thereby controlling the operation state of the power amplifier and then achieving PAE optimization.

In a third case, a remote parameter setting server instructs the parameter setting module inside the terminal to select PAE optimization design parameters.

Specifically, the location sensing module of the terminal reports a sensed current location to the remote parameter setting server. The parameter setting server determines an output power with the highest probability in the target output power range of the power amplifier in the terminal based on the current location of the terminal, and selects a first parameter suitable for the output power with the highest probability from the preset correspondence between output powers and operation parameters and sends the selected first parameter to the terminal through indication information. The parameter setting module in the terminal obtains the first parameter locally according to the indication information and configures the first parameter to the power amplifier, thereby controlling the operation state of the power amplifier and then achieving PAE optimization.

Step 303: using the first parameter to optimize and control the power added efficiency of the power amplifier.

Specifically, the first parameter can be used to adjust the static operation point of the power amplifier in the terminal, thereby controlling the power amplifier to be in a PAE-optimal operation state at the output power with the highest probability.

FIG. 5 is a schematic diagram showing a static operating point of a power amplifier. As shown in FIG. 5, considering that when amplifying AC signals, if the static operation point of the power amplifier is too high, saturation distortion may occur; or, if the static operation point of the power amplifier is too low, cutoff distortion may occur. Therefore, in order to meet nonlinear performance of large signals and prevent distortion of the power amplifier, it is generally necessary to place the static operation point at a midpoint. For small signals, there are no such restrictions. The large signal refers to a signal with a large power input to the power amplifier, and the small signal refers to a signal with a small power input to the power amplifier. The selection of the static operation point can also consider other factors such as power consumption. Therefore, adjusting the static operation point can simultaneously achieve nonlinear performance optimization under high power output and efficiency optimization under low power output.

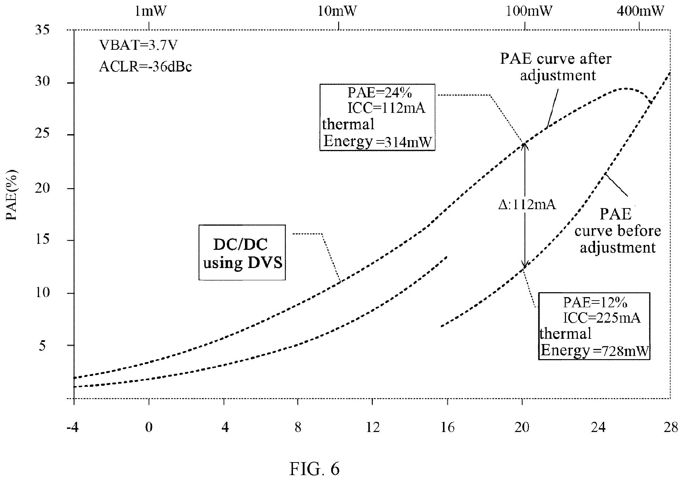

FIG. 6 is a schematic diagram showing an optimization result of a power added efficiency of a power amplifier. As shown in FIG. 6, the first parameter is used to adjust the static operation point of the power amplifier in the terminal to control the power amplifier to be in a PAE-optimal operation state. Comparing the PAE curve after adjustment with the PAE curve before adjustment, the power added efficiency of the power amplifier is significantly improved.

This example has the following advantages:
(1) an output power with the highest probability of the power amplifier in the terminal in the existing network is determined based on the current location of the terminal, and a first parameter suitable for the output power with the highest probability is selected for PAE optimization, thereby saving the power consumption of the terminal.

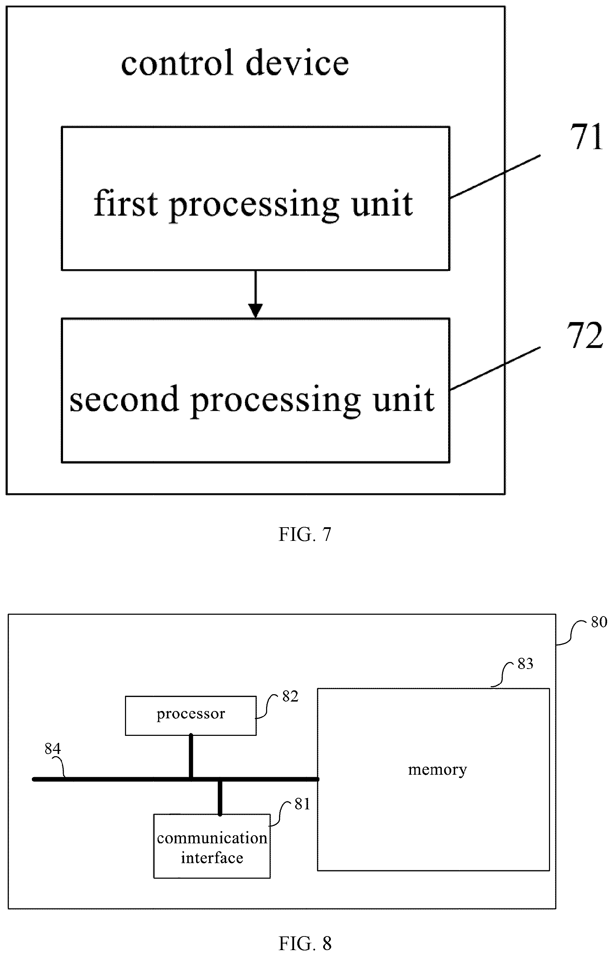

In order to implement the control method in the embodiment of the present disclosure, one embodiment of the present disclosure further provides a control device. FIG. 7 is a schematic diagram of the control device according to an embodiment of the present disclosure. As shown in FIG. 7, the device includes:
a first processing unit 71 configured to determine a first parameter corresponding to an output power with a highest occurrence probability in a target output power range of a power amplifier in a terminal, where the first parameter is used to optimize and control a power added efficiency of the power amplifier;
a second processing unit 72 configured to optimize the power added efficiency of the power amplifier by using the first parameter

In one embodiment, the first processing unit 71 is specifically configured to:
determine a second parameter; where the second parameter represents at least one of a current location of the terminal, a current ambient temperature of the terminal, a preset time range, and a future moment;
use the second parameter to determine the first parameter corresponding to the output power with the highest occurrence probability in the target output power range of the power amplifier in the terminal.

In one embodiment, the second parameter represents the current location of the terminal; the first processing unit 71 is specifically configured to:
determine the output power with the highest occurrence probability in the target output power range of the power amplifier in the terminal by using the current location of the terminal represented by the second parameter;
determining the first parameter according to the determined output power.

In one embodiment, the second parameter represents the current location of the terminal; the first processing unit 71 is specifically configured to:
transmit a current location of the terminal represented by the second parameter to the first server, where the current location of the terminal is used for the first server to determine the first parameter corresponding to the output power with the highest occurrence probability in the target output power range of the power amplifier in the terminal;
receive the first parameter transmitted by the first server.

In one embodiment, the second parameter represents the current location of the terminal; the first processing unit 71 is specifically configured to:
transmit the current location of the terminal represented by the second parameter to a second server, where the current location of the terminal is used for the second server to determine the first parameter corresponding to the output power with the highest occurrence probability in the target output power range of the power amplifier in the terminal;
receive indication information transmitted by the second server; where the indication information is used to indicate the first parameter;
determine the first parameter according to the indication information.

In one embodiment, the first processing unit 71 is specifically configured to:
determine a power headroom report; where the power headroom report carries first information and second information, the first information represents a difference between a terminal's maximum allowable transmission power and a currently evaluated transmission power of the physical uplink shared channel, and the second information represents a maximum allowable transmission power on a current carrier at a current serving cell;
transmit the power headroom report to the first network equipment; where the power headroom report is used for the first network equipment to parse to obtain the first information and the second information and send the first information and the second information to the first electronic device; the first information and the second information are used for the first electronic device to determine the output power with the highest occurrence probability in the target output power range of the power amplifier in the terminal in at least one of the following situations:
   at a location of the first network equipment;
   at an ambient temperature of the first network equipment;
   in a preset time range;
   in future moment;
   receive the output power sent by the first electronic device;
   determine the first parameter based on the output power.

In one embodiment, the first processing unit 71 is specifically configured to:
receiving the first parameter transmitted by a second electronic device; where the first parameter is an operation parameter corresponding to an output power with the highest occurrence probability in the target output power range of the power amplifier in the terminal, and the output power with the highest occurrence probability in the target output power range of the power amplifier in the terminal is determined by the second electronic device according to an output power probability distribution diagram of the power amplifier in the terminal obtained in at least one of the following situations:
at a location of the first network equipment;
at an ambient temperature of the first network equipment;
in a preset time range;
in future moments.

In one embodiment, the first processing unit 71 is specifically configured to:
obtain the first parameter from the terminal locally; where the first parameter is pre-written into the terminal by a third electronic device; the first parameter is an operation parameter corresponding to an output power with the highest occurrence probability in the target output power range of the power amplifier in the terminal, and the output power with the highest occurrence probability in the target output power range of the power amplifier in the terminal is determined by the third electronic device according to an output power probability distribution diagram of the power amplifier in the terminal obtained in at least one of the following situations:
at a location of the first network equipment;
at an ambient temperature of the first network equipment;
in a preset time range;
in future moments;
   or,
obtain the first parameter from the terminal locally; where the first parameter is pre-written into the terminal by a fourth electronic device; the first parameter is an operation parameter, which is determined by the fourth electronic device and is corresponding to an output power with the highest occurrence probability in the target output power range of the power amplifier in the terminal; and the output power with the highest occurrence probability in the target output power range of the power amplifier in the terminal is transmitted from the third electronic device to the fourth electronic device; and the output power with the highest occurrence probability in the target output power range of the power amplifier in the terminal is determined by the third electronic device according to an output power probability distribution diagram of the power amplifier in the terminal obtained in at least one of the following situations:
   at a location of the first network equipment;
   at an ambient temperature of the first network equipment;
   in a preset time range;
   in future moments;
      or,
   obtain the first parameter from the terminal locally; where the first parameter is pre-written into the terminal by a fifth electronic device; the first parameter is an operation parameter, which is determined by the fourth electronic device and is corresponding to an output power with the highest occurrence probability in the target output power range of the power amplifier in the terminal; the first parameter is transmitted from the fourth electronic device to the fifth electronic device; and the output power with the highest occurrence probability in the target output power range of the power amplifier in the terminal is transmitted from the third electronic device to the fourth electronic device; and the output power with the highest occurrence probability in the target output power range of the power amplifier in the terminal is determined by the third electronic device according to an output power probability distribution diagram of the power amplifier in the terminal obtained in at least one of the following situations:
      at a location of the first network equipment;
      at an ambient temperature of the first network equipment;
      in a preset time range;
      in future moments.

In one embodiment, the output powers with the highest occurrence probability in the target output power range of the power amplifier in the terminal form N first-output power ranges, and each first-output power range includes M output powers; N and M are both positive integer.

Each first-output power range includes the same or different amounts of output powers.

In actual application, the first processing unit 71 and the second processing unit 72 may be implemented by a processor in the control device.

It is to be noted that when the control device provided in the above embodiment performs control, the division of the above program modules is merely used as an example. In actual application, the above processing can be allocated to different program modules as needed, that is, internal structures of the device may be divided into different program modules to complete all or part of the processing described above. In addition, the control device provided by the above embodiments and the control method embodiments belong to the same concept. The specific implementation process of the control device can refer to the method embodiment and will not be repeated here.

One embodiment of the present disclosure further provides a terminal, as shown in FIG. 8, including:
a communication interface 81 capable of capable of exchanging information with other devices;
a processor 82 connected to the communication interface 81 and configured to, when running a computer program, execute the method provided by one or more technical solutions on the terminal side. The computer program is stored on a memory 83.

It is to be noted that the specific processing procedures of the processor 82 and the communication interface 81 may be refer to the method embodiments and will not be described again here.

Of course, in actual application, various components in the terminal 80 are coupled together through a bus system 84. It can be appreciated that the bus system 84 is used to implement connection communications between these components. In addition to a data bus, the bus system 84 further includes a power bus, a control bus and a status signal bus. However, for the sake of clarity, the various buses are labeled with the bus system 84 in FIG. 8.

The memory 83 in the embodiment of the present application is used to store various types of data to support the operation of the terminal 80. Examples of such data include: any computer program used to operate on the terminal 80.

The method disclosed in the above embodiments of the present application can be applied to the processor 82 or performed by the processor 82. The processor 82 may be an integrated circuit chip with signal processing capabilities. During the implementation process, each step of the above method may be completed by hardware integrated logic circuits or software instructions in the processor 82. The above processor 82 may be a general-purpose processor, a digital signal processor (DSP), or other programmable logic device, discrete gate or transistor logic device, discrete hardware components, etc. The processor 82 can implement or execute the disclosed methods, steps and logical block diagrams in the embodiments of the present application. The general-purpose processor may be a microprocessor or any conventional processor, etc. The steps of the method disclosed in the embodiments of the present application can be directly implemented by a hardware decoding processor, or executed by a combination of hardware and software modules in the decoding processor. The software module may be located in a storage medium, and the storage medium is located in the memory 83. The processor 82 reads information in the memory 83 and completes the steps of the foregoing method in combination with its hardware.

In an exemplary embodiment, the terminal 80 may be implemented as one or more application specific integrated circuits (ASICs), DSPs, programmable logic devices (PLDs), complex programmable logic devices (CPLD), Field-Programmable Gate Array (FPGA), general-purpose processor, controller, Micro Controller Unit (MCU), microprocessor, or other electronic components, used to execute the foregoing methods.

It can be understood that the memory (memory 83) in the embodiment of the present application may be a volatile memory or a non-volatile memory, or may include both volatile and non-volatile memories. The non-volatile memory can be read-only memory (ROM), programmable read-only memory (PROM), erasable programmable read-only memory (EPROM), Electrically Erasable Programmable Read-Only Memory (EEPROM), Ferromagnetic Random Access Memory (FRAM), Flash Memory, Magnetic Surface Memory, optical disk, or compact disc Read-Only Memory (CD-ROM). The magnetic surface memory can be a magnetic disk memory or a magnetic tape memory. The volatile memory may be random access memory (RAM), which is used as an external cache. By way of illustration but not limitation, many forms of RAM are available, such as Static Random Access Memory (SRAM), Synchronous Static Random Access Memory (SSRAM), Dynamic Random Access Memory (DRAM), synchronous dynamic random access memory (SDRAM), double data rate synchronous dynamic random access memory (DDRSDRAM), enhanced Synchronous Dynamic Random Access Memory (ESDRAM), Synclink Dynamic Random Access Memory (SLDRAM), Direct Rambus Random Access Memory (DRRAM). The memories described in the embodiments of the present application are intended to include, but are not limited to, these and any other suitable types of memories.

In an exemplary embodiment, one embodiment of the present disclosure further provides a storage medium, that is, a computer storage medium, specifically a computer-readable storage medium, such as a memory that stores a computer program. The computer program can be executed by the processor 82 of the terminal 80 to complete the steps described in the aforementioned terminal side method. The computer-readable storage medium may be memory such as FRAM, ROM, PROM, EPROM, EEPROM, Flash Memory, magnetic surface memory, optical disk, or CD-ROM.

It is to be noted that "first", "second", etc. are used to distinguish similar objects and are not necessarily used to describe a specific order or sequence.

In addition, the technical solutions described in the embodiments of the present disclosure may be combined arbitrarily as long as there is no conflict.

The above descriptions are only preferred embodiments of the present disclosure and are not intended to limit the scope of the present disclosure.

## Claims

1. A control method, applied to a terminal, comprising:
determining a first parameter corresponding to an output power with a highest occurrence probability in a target output power range of a power amplifier in a terminal, wherein the first parameter is used to optimize and/or control a power added efficiency of the power amplifier;
optimizing and/or controlling the power added efficiency of the power amplifier by using the first parameter.

2. The method according to claim 1, wherein the determining a first parameter corresponding to an output power with a highest occurrence probability in a target output power range of a power amplifier in a terminal, comprises:
determining a second parameter; wherein the second parameter represents at least one of a current location of the terminal, a current ambient temperature of the terminal, a preset time range, and a future moment;
using the second parameter to determine the first parameter corresponding to the output power with the highest occurrence probability in the target output power range of the power amplifier in the terminal.

3. The method according to claim 2, wherein the second parameter represents the current location of the terminal; the using the second parameter to determine the first parameter corresponding to the output power with the highest occurrence probability in the target output power range of the power amplifier in the terminal, comprises:
determining the output power with the highest occurrence probability in the target output power range of the power amplifier in the terminal by using the current location of the terminal represented by the second parameter;
determining the first parameter according to the determined output power.

4. The method according to claim 2, wherein the second parameter represents the current location of the terminal; the using the second parameter to determine the first parameter corresponding to the output power with the highest occurrence probability in the target output power range of the power amplifier in the terminal, comprises:
transmitting the current location of the terminal represented by the second parameter to a first server, wherein the current location of the terminal is used for the first server to determine the first parameter corresponding to the output power with the highest occurrence probability in the target output power range of the power amplifier in the terminal;
receiving the first parameter transmitted by the first server.

5. The method according to claim 2, wherein the second parameter represents the current location of the terminal; the using the second parameter to determine the first parameter corresponding to the output power with the highest occurrence probability in the target output power range of the power amplifier in the terminal, comprises:
transmitting the current location of the terminal represented by the second parameter to a second server, wherein the current location of the terminal is used for the second server to determine the first parameter corresponding to the output power with the highest occurrence probability in the target output power range of the power amplifier in the terminal;
receiving indication information transmitted by the second server; wherein the indication information is used to indicate the first parameter;
determining the first parameter according to the indication information.

6. The method according to claim 1, wherein the determining a first parameter corresponding to an output power with a highest occurrence probability in a target output power range of a power amplifier in a terminal, comprises:
determining a power headroom report; wherein the power headroom report carries first information and second information, the first information represents a difference between a terminal's maximum allowable transmission power and a currently evaluated transmission power of a physical uplink shared channel, and the second information represents a terminal's maximum allowable transmission power on a current carrier at a current serving cell;
transmitting the power headroom report to a first network equipment; wherein the power headroom report is used for the first network equipment to parse to obtain the first information and the second information and send the first information and the second information to a first electronic device; the first information and the second information are used for the first electronic device to determine the output power with the highest occurrence probability in the target output power range of the power amplifier in the terminal in at least one of the following situations: at a location of the first network equipment, at an ambient temperature of the first network equipment, in a preset time range, and in future moment;
receiving the output power with the highest occurrence probability sent by the first electronic device;
determining the first parameter based on the output power.

7. The method according to claim 1, wherein the determining a first parameter corresponding to an output power with a highest occurrence probability in a target output power range of a power amplifier in a terminal, comprises:
receiving a first parameter transmitted by a second electronic device; wherein the first parameter is an operation parameter corresponding to an output power with the highest occurrence probability in the target output power range of the power amplifier in the terminal, and the output power with the highest occurrence probability in the target output power range of the power amplifier in the terminal is determined by the second electronic device according to an output power probability distribution diagram of the power amplifier in the terminal obtained in at least one of the following situations:
at a location of the first network equipment;
at an ambient temperature of the first network equipment;
in a preset time range;
in future moments.

8. The method according to claim 1, wherein the determining a first parameter corresponding to an output power with a highest occurrence probability in a target output power range of a power amplifier in a terminal, comprises:
obtaining the first parameter from the terminal; wherein the first parameter is pre-written into the terminal by a third electronic device; the first parameter is an operation parameter corresponding to an output power with the highest occurrence probability in the target output power range of the power amplifier in the terminal, and the output power with the highest occurrence probability in the target output power range of the power amplifier in the terminal is determined by the third electronic device according to an output power probability distribution diagram of the power amplifier in the terminal obtained in at least one of the following situations:
at a location of the first network equipment;
at an ambient temperature of the first network equipment;
in a preset time range;
in future moments;
or,
obtaining the first parameter from the terminal; wherein the first parameter is pre-written into the terminal by a fourth electronic device; the first parameter is an operation parameter, which is determined by the fourth electronic device and is corresponding to an output power with the highest occurrence probability in the target output power range of the power amplifier in the terminal; and the output power with the highest occurrence probability in the target output power range of the power amplifier in the terminal is transmitted from the third electronic device to the fourth electronic device; and the output power with the highest occurrence probability in the target output power range of the power amplifier in the terminal is determined by the third electronic device according to an output power probability distribution diagram of the power amplifier in the terminal obtained in at least one of the following situations:
at a location of the first network equipment;
at an ambient temperature of the first network equipment;
in a preset time range;
in future moments;
or,
obtaining the first parameter from the terminal; wherein the first parameter is pre-written into the terminal by a fifth electronic device; the first parameter is an operation parameter, which is determined by the fourth electronic device and is corresponding to an output power with the highest occurrence probability in the target output power range of the power amplifier in the terminal; the first parameter is transmitted to the fifth electronic device; and the output power with the highest occurrence probability in the target output power range of the power amplifier in the terminal is transmitted from the third electronic device to the fourth electronic device; and the output power with the highest occurrence probability in the target output power range of the power amplifier in the terminal is determined by the third electronic device according to an output power probability distribution diagram of the power amplifier in the terminal obtained in at least one of the following situations:
at a location of the first network equipment;
at an ambient temperature of the first network equipment;
in a preset time range;
in future moments.

9. The method according to any one of claims 1 to 8, wherein output powers with the highest occurrence probability in the target output power range of the power amplifier form N first-output power ranges, and each of the first-output power range includes M output powers; N, M are positive integers;
wherein each of the first-output power range includes the same or different amounts of output powers.

10. A control device, comprising:
a first processing unit configured to determine a first parameter corresponding to an output power with a highest occurrence probability in a target output power range of a power amplifier in a terminal, wherein the first parameter is used to optimize and/or control a power added efficiency of the power amplifier;
a second processing unit configured to optimize and/or control the power added efficiency of the power amplifier by using the first parameter.

11. A terminal, comprising:
a communication interface;
a processor configured to determine a first parameter corresponding to an output power with a highest occurrence probability in a target output power range of a power amplifier in a terminal, wherein the first parameter is used to optimize and/or control a power added efficiency of the power amplifier; and optimize and/or control the power added efficiency of the power amplifier by using the first parameter.

12. A terminal, comprising: a processor and a memory for storing a computer program capable of executed by the processor;
wherein the processor is configured to, when executing the computer program, perform steps of the method according to any one of claims 1 to 9.

13. A computer-readable storage medium, comprising a computer program stored thereon; wherein the computer program, when executed by a processor, performs steps of the method according to any one of claims 1 to 9.
